# EUROPEAN PATENT APPLICATION

(11) **EP 0 942 461 A2**
(43) Date of publication of application: **15.09.1999**
(21) Application number: 99301757.3
(22) Date of filing: 09.03.1999
(51) Int. Cl.: H01L 21/306, H01L 21/308

(54) **Reduction of black silicon in semiconductor fabrication**

(30) Priority: 11.03.1998 US 38383
(71) Applicant: SIEMENS AKTIENGESELLSCHAFT, 80333 München (DE); International Business Machines Corporation, Armonk, NY 10504 (US)
(72) Inventor: Wang, Ting-Hao, Round Rock, Texas 78681 (US); Perng, Dung-Ching, San Jose, CA 95132 (US); Dobzinsky, Dave M., Hopewell Junction, NY 12533 (US); Wise, Richard S., Hopewell Junction, NY 12533 (US)
(74) Representative: Litchfield, Laura Marie

(57) **Abstract**

Reduction of black silicon is achieved by providing a protective device layer in the bead region and sides of the wafer before the formation of a hard etch mask.

## Description

The invention generally relates to semiconductor fabrication and, more particularly, to a process for reducing the formation of black silicon.

In the fabrication of integrated circuits (ICs) or chips, vias or trenches are typically created in the substrate, such as a silicon wafer, for various purposes. The vias or trenches are formed by etching into the substrate. Deep trenches (DTs), for example, serve as trench capacitors for an array of memory cells.

DTs are normally formed by first providing a pad stack over the surface of the wafer. The pad stack includes, for example, sequential layers of a pad oxide and a pad nitride. Above the pad stack is a hard mask layer comprising, for example, TEOS. The hard mask layer serves as a hard etch mask used to form the DTs.

A photoresist layer is deposited over the hard mask and patterned to selectively expose regions where the DTs are to be formed. Typically, the exposed regions of the hard mask removed by a reactive ion etch (RIE) to expose portions of the pad stack beneath. This etch step to remove the hard mask is referred to as the hard mask open etch. The exposed portion of the pad stack is removed to expose the silicon wafer. The exposed silicon portions are etched by RIE, forming the DTs.

However, known mask open and DT etches consumes the hard mask material at a greater rate at the wafer edge compared to the rest of the wafer because of uneven plasma coverage. This phenomenon, which is sometimes known as the bulls-eye effect, results in the hard mask material being depleted form the wafer edge. The pad stack in the edges and sides is eroded away during the latter stages of the DT etch, exposing the wafer surface beneath in those regions. As the DT etch continues, formation of needle type surface at the exposed regions of the wafer results. Such needle type surface is referred to as "black silicon." A description of black silicon can be found in, for example, V. W. Hess, Solid State Technology, April 1981, p. 192 and G. K. Herb, Solid State Technology, October 1989, p. 104.

Black silicon forms because the micromasking of the hard mask on the surface as the silicon is etched. In the latter stages of the DT etch, islands of hard etch material are left on the wafer surface. The islands protect the underlying silicon from being etched. As such, the portions unprotected by the islands continue to be etched, while the protected portions remain. As the RIE proceeds, the protected portions results in the formation of needles or spikes.

The formation of black silicon during RIE creates difficulties in the handling of the wafer. For example, the black silicon spikes are easily broken off and can adversely impact manufacturing yield.

One known technique of preventing the formation of black silicon is to employ a clamp ring to cover the wafer edge, protecting it during hard mask open RIE. However, the use of the clamp ring causes clamp finger shadowing, which affects lithographic resolution or reliability and etch uniformity. As a result, chip yield is reduced. Additionally, the use of the clamp ring prevents the use of electric static chuck (ESC) equipped tools, which are required in high density plasma etch tools.

From the foregoing discussion, it is desirable to provide an improved technique of fabricating semiconductor devices without the formation of black silicon.

The invention relates to the reduction of black silicon during the fabrication of semiconductor devices. The formation of black silicon is reduced by providing a protective device layer in the bead and sides of the wafer. In one embodiment, the protective device layer is deposited conformally on a wafer surface and patterned to remove it from the primary chip region. A pad stack and hard mask are then deposited over the wafer. The device layer, although not necessary, is formed from the material used to form the hard mask. The protective device layer at the bead and sides of the wafer provides additional protection during DT etch, reducing or preventing the formation of black silicon.

For a better understanding of the present invention, and to show how it may be brought into effect, reference will now be made, by way of example, to the accompanying drawings, in which:
Fig. 1 shows a DRAM cell; and
Figs. 2a-d show an embodiment of the invention for preventing formation of black silicon during fabrication of integrated circuits.

The present invention relates to prevention of black silicon during the fabrication of integrated circuits (ICs). The ICs, for example, include memory circuits such as random access memories (RAMs), dynamic RAMs (DRAMs), synchronous DRAMs (SDRAMs), static RAMs (SRAMs), or read only memories (ROMs). Also, the ICs may include logic devices such as a programmable logic arrays (PLAs), application specific ICs (ASICs), merged DRAM-logic ICs (embedded DRAMs), or any other circuit devices.

Typically, numerous ICs are fabricated on a substrate, such as a silicon wafer, in parallel. After processing, the wafer is diced in order to separate the ICs into a plurality of individual chips. The chips are then packaged into final products for use in, for example, consumer products such as computer systems, cellular phones, personal digital assistants (PDAs), and other products.

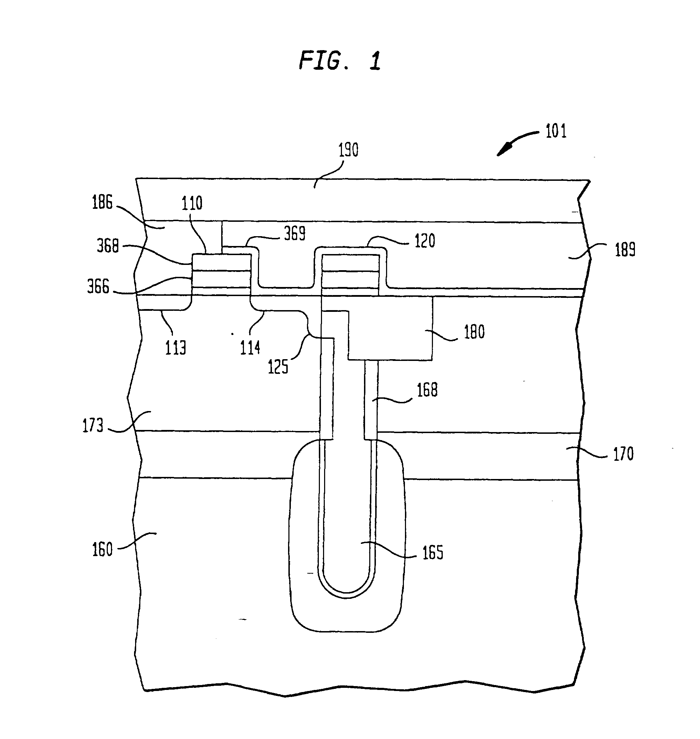

For purpose of discussion, a description of a conventional DRAM cell is provided. Referring to Fig. 1, a trench capacitor DRAM cell is shown. Such DRAM cell is described in, for example, Nesbit et al., A 0.6 mm₂ 256Mb Trench DRAM Cell With Self-Aligned Buried Strap (BEST), IEDM 93-627.

As shown, the DRAM cell includes a trench capacitor 160 formed in a substrate 101. The trench is filled with, typically, polysilicon (poly) 161 that is heavily doped with n-dopants. The poly serves as one plate of the capacitor, is referred to as a "storage node." A buried plate 165 doped with n-type dopants surrounds the lower portion of the trench. In the upper portion of the trench is a collar 168 for reducing parasitic leakage. A node dielectric 163 separates the two plates of the capacitor. A buried well 170 comprising n-type dopants is provided to connect the buried plates of the DRAM cells in the array. Above the buried well is a p-well 173. The p-well serves to reduce vertical leakage.

The DRAM cell also comprises a transistor 110. The transistor includes a gate 112 and diffusion regions 113 and 114 comprising n-type dopants. The diffusion regions are referred to as the source and drain. The designation of source and drain depends on the operation of the transistor. Connection of the transistor to the capacitor is achieved via a diffusion region 125, referred to as the "node diffusion." The gate, also referred to as the "wordline," typically comprises poly 366 and nitride 368 layers.
Alternatively, layer 357 is a polycide layer which comprises silicide, such as molybdenum (MoSiₓ), tantalum (TiSiₓ), tungsten (WSiₓ), titanium (TiSiₓ), or cobalt (CoSiₓ), over a layer of poly to reduce wordline resistance.

In one embodiment, the polycide layer comprises Wsiₓ over poly. A nitride liner 369 covers the gate stack and substrate. The nitride layer 368 and nitride liner serves as an etch or polish stop layer for subsequent processing.

A shallow trench isolation (STI) 180 is provided to isolate the DRAM cell from other cells or devices. As shown, a wordline 120 is formed over the trench and isolated therefrom by the STI. Wordline 120 is referred to as the "passing wordline." Such configuration is referred to as a folded bitline architecture. Other configurations such as open or open-folded bitline architectures or cell designs are also useful.

An interlevel dielectric layer 189 is formed over the wordlines. A conductive layer, representing a bitline, is formed over the interlevel dielectric layer. A bitline contact opening 186 is provided in the interlevel dielectric layer to contact the source 113 to the bitline 190.

A plurality of such cells is configured in an array. The array of cells is interconnected by wordlines and bitlines. Access to a cell is achieved by activating the cell's corresponding wordline and bitline.

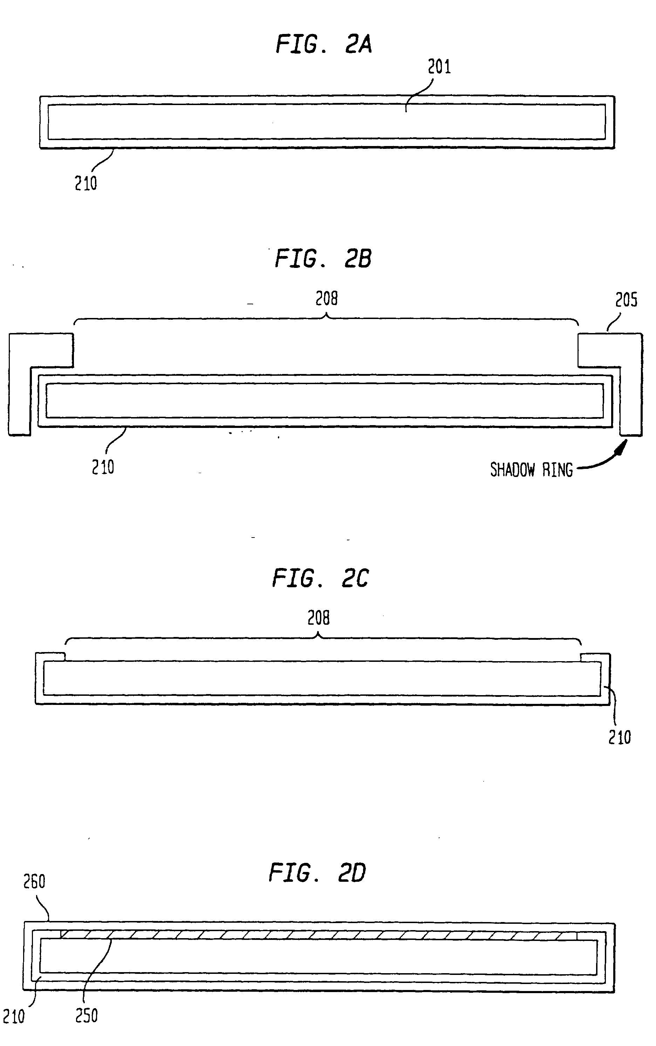

Referring to Fig. 2a, a substrate 201 on which integrated circuits are formed is shown. The substrate, for example, includes a silicon wafer. Other types of substrate, such as silicon on insulator (SOI), silicon on sapphire (SOS), germanium, gallium arsenide, or group III-V compounds, are also useful.

A device layer 210 is formed on the wafer. As shown, the device layer conformally covers wafer surfaces, including the sides and bottom. Preferably, the device layer comprises material similar to the hard mask material used for the DT etch. In one embodiment, the device layer comprises oxide. Other hard mask materials are also useful to form the device layer.

The oxide is formed by, for example, decomposing TEOS using chemical vapor deposition (CVD) techniques such as low pressure CVD (LPCVD). Other conformal oxide deposition techniques are also useful. The thickness of the TEOS layer is sufficient to prevent exposure of the wafer edges during DT etch. Typically, the thickness of the TEOS layer is about 1000-2000Å. This thickness may vary depending on, for example, etch chemistry, etch efficiency, hard mask material, and depth of the DTs.

Referring to Fig. 2b, at least the edge and side of the wafer where black silicon occurs are protected while the region 208 where ICs are formed is unprotected. The term "primary chip region" is used herein to refer to the region of the wafer in which ICs are formed. The edge portion of the wafer that is protected is typically referred to the bead region. The width of the bead region is typically about 3mm wide, but it may vary in accordance with specific designs and layout of the chips on the wafer.

In one embodiment, a wafer supporter 205 such as a shadow ring is employed to protect the edge of the wafer. Such wafer supporter is found in, for example, AMAT Omega, MxP, or MxP+ etch tools equipped with a shadow ring. A modified clamp ring may also be used to protect the bead region.

Alternatively, a resist layer can be employed and patterned to protect the edge and bead regions of the wafer. This includes depositing the resist layer without employing bead removal, allowing the resist to protect the bead and edge regions. A blank mask is used to selectively expose the resist to allow the resist in the primary chip region to be removed during development.

Referring to Fig. 2c, the unprotected portion of the TEOS layer 210 in the primary chip region 208 is removed selective to the wafer. Removal of the device layer is achieved by, for example, RIE, wet etch, or chemical dry etch (CDE) using appropriate chemistry to remove the TEOS selective to silicon. Preferably, a wet etch or CDE is employed as it does not cause damage to the silicon as RIE. When an RIE is used, subsequent thermal processes or a separate anneal serves to heal the silicon damage.

Referring to Fig. 2d, a pad stack 250 is formed on the wafer in the primary chip region. The pad stack typically comprises a pad oxide layer and a pad stop layer. The pad oxide layer is deposited by, for example, thermal oxidation. The pad oxide is sufficiently thick to reduce stress and promote adhesion between the pad stop layer with the wafer. Typical thickness of the pad oxide layer is about 5-20 nm, preferably about 10 nm.

Above the pad oxide is the pad stop layer. The pad stop layer comprises material having sufficient selectivity to other material, such as that used to fill the DTs, to serve as an efficient etch or CMP stop layer. In one embodiment, the pad stop layer comprises silicon nitride (Si₃N₄) due to its relatively low etch rate to the polysilicon used to fill the trenches. Other appropriate etch or CMP stop materials are also useful to form the pad stop layer. The nitride layer is deposited by, for example, low pressure chemical vapor deposition (LPCVD). Other techniques for depositing the nitride layer, such as plasma enhanced chemical vapor deposition (PECVD), are also useful. Typically, the pad nitride layer is about 100-300 nm thick, and preferably about 200-220 nm. The thickness may, however, vary depending the application and CMP performance or etch efficiency as well as etch selectivity between the nitride and resist used to pattern the nitride.

Although, as described, the pad stack comprises a pad oxide and pad stop layers, additional layers may be included depending on the application.

After the formation of the pad stack, a hard mask layer 260 is deposited on the wafer surface. The hard mask comprises, in one embodiment, oxide formed from TEOS. As shown, the TEOS layer is formed by LPCVD and covers the wafer surfaces, including the sides and bottom. Other materials which have a high etch selectivity to silicon can also be used as a hard etch mask. Such materials include, for example, borosilicate glass (BSG). The hard etch mask serves as the mask for etching DTs. The thickness of the hard mask layer is, for example, about 700nm. Of course, this thickness may vary depending on the depth of the DTs and the etch process that is employed.

The hard mask layer is patterned using conventional lithographic techniques to define regions in which DTs are formed. Such techniques include depositing a photoresist layer and selectively exposing it with an exposure source and mask. Either exposed or unexposed portion of the resist, depending on whether it is a positive or negative type resist, is removed during development. As a result, the hard mask in the DT regions is unprotected by the resist layer. The hard mask material along with the other layers of the pad stack in the DT regions are then removed, exposing the silicon wafer underneath. Removal of the unprotected portions of the pad stack layers is achieved by, for example, for example, reactive ion etching (RIE).

After the pad stack has been patterned, a DT etch is performed to create the DTs. The DT etch, for example, is a RIE. Since the device layer 210 provides additional protection at the edge of the wafer, the DT etch does not penetrate through to the wafer. As a result, formation of black silicon is prevented.

The hard mask layer is patterned using conventional lithographic techniques to define regions in which DTs are formed. Such techniques include depositing a photoresist layer and selectively exposing it with an exposure source and mask. Either exposed or unexposed portion of the resist, depending on whether it is a positive or negative type resist, is removed during development. As a result, the hard mask in the DT regions is unprotected by the resist layer. The hard mask material along with the other layers of the pad stack in the DT regions are then removed, exposing the silicon wafer underneath. Removal of the pad stack layers is achieved by, for example, for example, RIE.

After the pad stack has been patterned, a DT etch is performed to create the DTs. The DT etch, for example, is a RIE. The oxide layer 210 provides additional protection at the bead region and sides of the wafer. As a result, the DT etch does not penetrate through to the wafer in the bead region and sides, preventing the formation of black silicon in these regions.

The process continues to form the remaining portions of the ICs. This, for example, includes forming a plurality of DRAM cells as described in Fig. 1, along with support devices to fabricate DRAM chips.

While the invention has been particularly shown and described with reference to various embodiments, it will be recognized by those skilled in the art that modifications and changes may be made to the present invention without departing from its scope. The scope of the invention should therefore be determined not with reference to the above description but with reference to the appended claims along with their full scope of equivalents.

## Claims

1. A process for fabricating semiconductor devices comprising:
forming a device layer conformally on the surfaces of the wafer;
patterning the device layer to selectively remove the device layer from a primary chip region, leaving the device layer remaining at least a bead region;
forming a pad stack in the primary chip region; and
forming a hard mask layer over, the hard mask layer covering at least the pad stack and the device layer over the bead region.

2. Semiconductor devices fabricated using the process of claim 1.
